# FASCICULE DE BREVET EUROPEEN

(11) **EP 0 762 577 B1**
(45) Date de publication et mention de la délivrance du brevet: **09.02.2000**
(21) Numéro de dépôt: 96401902.0
(22) Date de dépôt: 05.09.1996
(51) Int. Cl.: H01S 5/06, H01S 5/02, G02F 1/015, H04B 10/155, H04J 14/02

(54) **Dispositif d'émission semi-conducteur avec modulation rapide de longueur d'onde**
Halbleitende Emissionsvorrichtung mit schneller Wellenlängenmodulation
Semiconducting emission device with fast wavelength modulation

(30) Priorité: 08.09.1995 FR 9510545
(43) Date de publication de la demande: 12.03.1997
(73) Titulaire: FRANCE TELECOM, 75015 Paris (FR)
(72) Inventeur: Nakajima, Hisao, 92220 Bagneux (FR); Charil, Josette, 92190 Meudon (FR); Slempkes, Serge, 78100 St Germain en Laye (FR)
(74) Mandataire: Dubois-Chabert, Guy

(56) Documents cités:
- EP-A- 0 484 228
- US-A- 5 088 097
- IEEE PHOTONICS TECHNOLOGY LETTERS, vol. 5, no. 3, Mars 1993, NEW YORK, US, pages 354-356, XP000362942 S.KUWANO ET AL.: "100ps frequency switching without bit loss for a 10Gb/s ASK modulated signal"
- I.E.E.E. JOURNAL OF SELECTED TOPICS IN QUANTUM ELECTRONICS, vol. 1, no. 2, 1 Juin 1995, NEW YORK, US, pages 396-400, XP000521103 DELORME F ET AL: "Subnanosecond tunable distributed Bragg reflector lasers with an electrooptical Bragg section"
- I.E.E.E. JOURNAL OF SELECTED TOPICS IN QUANTUM ELECTRONICS, vol. 1, no. 2, 1 Juin 1995, NEW YORK, US, pages 516-522, XP000521112 SHIM J -I ET AL: "1.5-um InGaAsP-InP multigain-levered-MQW-DFB-LD with high-efficiency and large-bandwidth FM response"
- IEEE PHOTONICS TECHNOLOGY LETTERS, vol. 7, no. 2, 1 Février 1995, pages 185-187, XP000488093 ALLOVON M ET AL: "MONOLITHIC INTEGRATION ON INP OF A WANNIER STARK MODULATOR WITH A STRAINED MQW DFB 1.55- M LASER"

## Description

### Domaine technique

La présente invention concerne un dispositif d'émission semi-conducteur, par exemple un laser DFB ("Distributed Feedback" ou à contre-réaction distribuée), avec modulation rapide de longueur d'onde.

### Etat de la technique antérieure

Une modification rapide de la longueur d'onde d'émission peut être réalisée avec un laser DBR ("Distributed Bragg Reflector" ou à réflecteur de Bragg distribué) ayant une section DBR électro-optique (E-O) (voir référence [1] ou un laser DFB à trois électrodes (voir référence [2]). Pour un laser DBR, un temps de commutation de 600 ps est mesuré pour trois modes espacés de 0,35 nm. Le temps de commutation est limité par la capacité parasite de la section DBR. Pour un laser DFB à trois électrodes, le temps de commutation est de 100 ps et de 400 ps respectivement pour une excursion de 0,16 nm (20 GHz) et 0,64 nm (80 GHz). Dans ce cas, le temps de commutation est déterminé par la durée de vie de porteurs effective, qui est approximativement inversement proportionnelle à la densité de photons, et au gain différentiel. Pour la modulation de fréquence, une très large bande passante de 18 GHz est obtenue avec un laser DFB MQW (puits quantiques multiples) mono-section de 90 µm de long et un laser DFB MQW à deux sections. L'efficacité FM (modulation de fréquence) est respectivement de 0,9 GHz/mA (voir référence [3]) et de 1,5 GHz/mA (voir référence [4]).

Un laser DBR E-O peut être très rapide et est bien adapté pour effectuer une commutation de longueur d'onde. Actuellement, le temps de commutation est limité par la capacité parasite de la section DBR. Bien que la plage d'accord du laser DBR soit plus grande que celle du laser DFB, la modification de la longueur d'onde se fait d'une façon discontinue par saut. Cette caractéristique est à la fois très intéressante et très gênante en fonction des applications souhaitées, car l'espacement des longueurs d'onde ne peut être très petit (<0,2 nm) à cause de la limitation en longueur (≈2 mm). Cette caractéristique est très gênante pour des applications utilisant une plage d'accord (quasi-)continue.

Pour un laser DFB trois (ou deux) électrodes, le temps de commutation est limité par la durée de vie effective de porteurs. Le temps de commutation augmente avec l'excursion de la longueur d'onde. Il faut y ajouter une limitation due au produit RC de la section modulée. Une combinaison de ces éléments limite le temps de commutation à 100 ps environ.

L'invention a pour objet l'obtention d'un émetteur pouvant commuter très rapidement ses longueurs d'onde de fonctionnement (émission laser).

### Exposé de l'invention

La présente invention concerne un dispositif d'émission semi-conducteur avec modulation rapide de longueur d'onde, caractérisé en ce qu'il est composé de trois sections, deux sections latérales qui comportent chacune une couche active et un réseau DFB et qui produisent un gain optique, reliées au travers d'une section centrale électroabsorbante, à laquelle est appliquée une tension en inverse qui permet de modifier quasi-instantanément le taux d'absorption dans cette section.

Avantageusement ce dispositif d'émission semi-conducteur est un laser DFB.

La présente invention peut, dans le domaine des télécommunications optiques être appliquée à :
- un émetteur du signal modulé en longueur d'onde (ou en fréquence) très haut débit (> 10 Gb/s) ;
- un commutateur de longueurs d'onde très rapide (< 100 ps) ;
- un émetteur d'impulsions optiques (du type soliton); haut débit (> 5 Gb/s).

Les premiers dispositifs réalisés ont montré une émission en modulation de longueur d'onde à 10 Gb/s et un temps de commutation de la longueur d'onde inférieur 100 ps pour une excursion de 0,3 nm. Ce temps est très peu dépendant de l'excursion de la longueur d'onde. Avec une modulation impulsionnelle de 5 à 10 Gb/s, des impulsions optiques de 40 ps de durée et de très faible chirp (< 0,03 nm) on été générées.

### Brève description des figures

- La figure 1 illustre le principe fonctionnel du dispositif de l'invention ;
- la figure 2 illustre la variation du nombre de porteurs en fonction du temps pour un courant de 100 mA, et pour différentes constantes de temps ;
- la figure 3 illustre la variation du nombre de porteurs en fonction du temps pour un courant de 200 mA, et pour différentes constantes de temps ;
- la figure 4 illustre la structure de base d'un laser DFB selon l'invention ;
- la figure 5 illustre la puissance optique en fonction du courant pour différentes tensions en inverse pour le laser illustré sur la figure 4 ;
- les figures 6A et 6B représentent respectivement la longueur d'onde et la puissance relative en fonction de la tension en inverse pour le laser illustré sur la figure 4 ;
- la figure 7 illustre le spectre d'émission de ce laser à I = 71mA ;
- la figure 8 illustre la variation de la longueur d'onde mesurée en appliquant un signal pseudo-aléatoire NRZ (non retour à zéro) 2⁷-1 de 10 G bit/s sur la section centrale ;
- la figure 9 illustre le diagramme de l'oeil NRZ à 10 Gbit/s ;
- la figure 10 illustre la forme temporelle d'une impulsion générée ;
- la figure 11 illustre la répartition spectro-temporelle de la puissance optique d'une impulsion ;
- la figure 12 illustre l'évolution temporelle de la longueur d'onde correspondant à la puissance maximale à un l'instant donné ;
- la figure 13 illustre une section absorbante à puits quantiques multiples ;
- la figure 14 illustre une structure avec semi-isolant ;
- la figure 15 illustre une structure obtenue par l'épitaxie sélective en surface ;
- la figure 16 illustre une structure à couplage évanescent ;
- la figure 17 illustre un émetteur du signal modulé en longueur d'onde (ou en fréquence) très haut débit (> 10 Gbits/s) ;
- la figure 18 illustre un commutateur de longueurs d'onde très rapide (< 100 ps) ;
- la figure 19 illustre un émetteur d'impulsions optiques, du type soliton, haut débit (> 5 Gbits/s).

### Exposé détaillé de l'invention

L'invention concerne une structure laser DFB composée de trois sections 10, 11 et 12. Deux sections latérales 10 et 11, comportant chacune une couche active 13, 14 et un réseau DFB 15, produisent un gain optique. Elles sont reliées au travers d'une section centrale 12 comprenant une couche électroabsorbante 16. Ces trois sections sont munies sur une face d'une électrode spécifique, respectivement référencées 17, 18, 19 et sur leur autre face d'une électrode commune 20. L'application d'une tension en inverse -V sur la section centrale permet de modifier quasi-instantanément le taux d'absorption dans cette section, via l'effet électroabsorbant : par exemple, l'effet Franz-Keldysh décrit dans la référence [5], l'effet Stark quantique confiné décrit dans la référence [6] etc. Cette variation induit à son tour une variation de la densité de porteurs au seuil (qui correspond au début de l'effet laser) et modifie l'indice de réfraction des couches actives. Ceci conduit à une modification de la longueur d'onde d'émission laser. Le temps de réponse dépend d'une part de la constante de temps de la section centrale et d'autre part de la fréquence de résonance intrinsèque fr des couches actives. Le temps de réponse est déterminé par une convolution de ces deux facteurs. La constante de temps de la section électroabsorbante est déterminée par la capacité parasite, car la constante de temps de l'effet électroabsorbant est nulle. Avec une capacité de 0,5 pF (pour une section de 50 µm de long), qui est une valeur facilement réalisable avec une structure semi-isolante), on obtiendrait un produit RC de 25 ps correspondant à un débit de 40 Gbits/s. Cependant, le débit maximum est obtenu en tenant compte de la constante de temps associée à la fréquence de résonance (≈ 0,5/fr). Ce qui permet d'obtenir un laser rapide en modulation de longueur d'onde dont la bande passante est limitée par la fréquence de résonance intrinsèque.

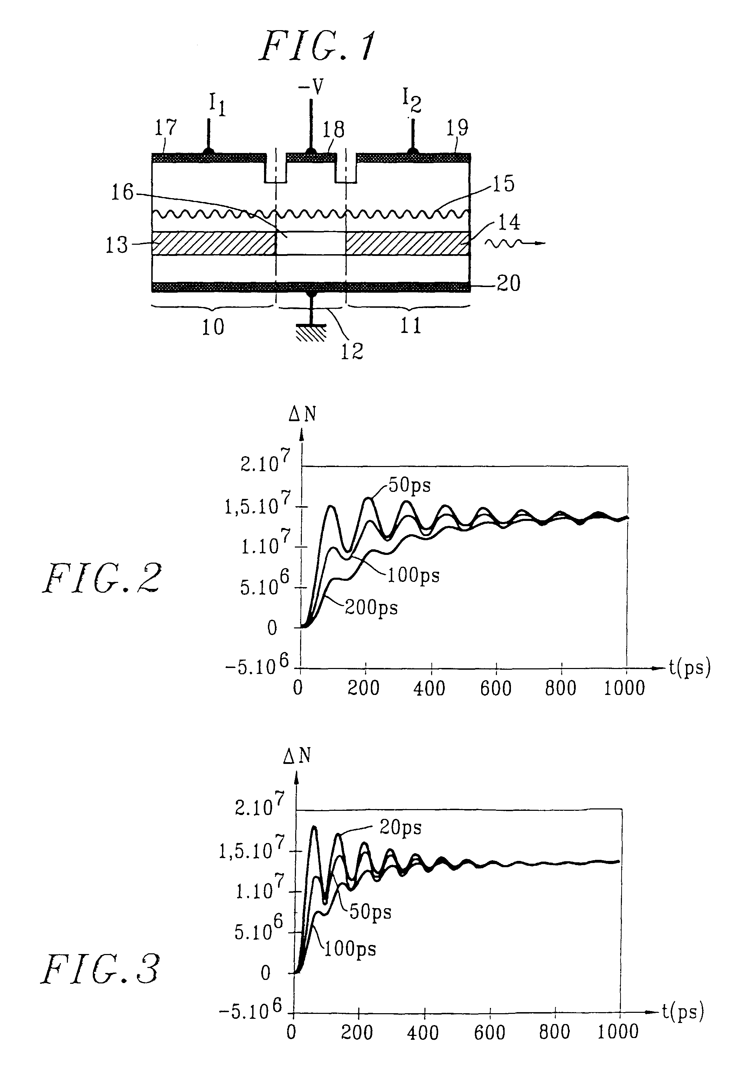

Afin de montrer la validité de cette approche, une modélisation basée sur les "Rates Equations", décrites dans la référence [10], a été réalisée. Les équations ont été résolues dans le cadre d'une approximation en petits signaux. La variation de longueur d'onde Δλ peut être calculée à partir de la variation d'indice dn = Γdn/dN∗ΔN, Γ étant le facteur de confinement, induite par une variation de la densité de porteurs ΔN par Δλ = 2∗pas∗dn, "pas" étant le pas de réseau. On suppose ici que l'application d'une tension en inverse sur la section absorbante induit une augmentation de l'absorption d'une façon linéaire, ce qui est une approximation. On examine l'effet de la constante de temps de cette augmentation sur la densité de porteurs. Pour un courant de fonctionnement du laser I = 100 mA, la période de l'oscillation de relaxation est de 120 ps environ. Lorsque la constante de temps devient plus faible que la demi-période de l'oscillation (60 ps), c'est l'oscillation de relaxation qui détermine le temps de réponse : ainsi la figure 2 illustre la variation du nombre de porteurs ΔN en fonction du temps t pour I = 100 mA, pour différentes constantes de temps. Cette situation est similaire pour I = 200 mA où la demi-période est de 40 ps, comme représenté sur la figure 3. Le temps de commutation minimum est d'environ 60 ps et 40 ps respectivement pour 100 et 200 mA.

On va à présent décrire quelques modes particuliers de réalisation.

### Laser DFB avec une section centrale électroabsorbante

### Structure de base

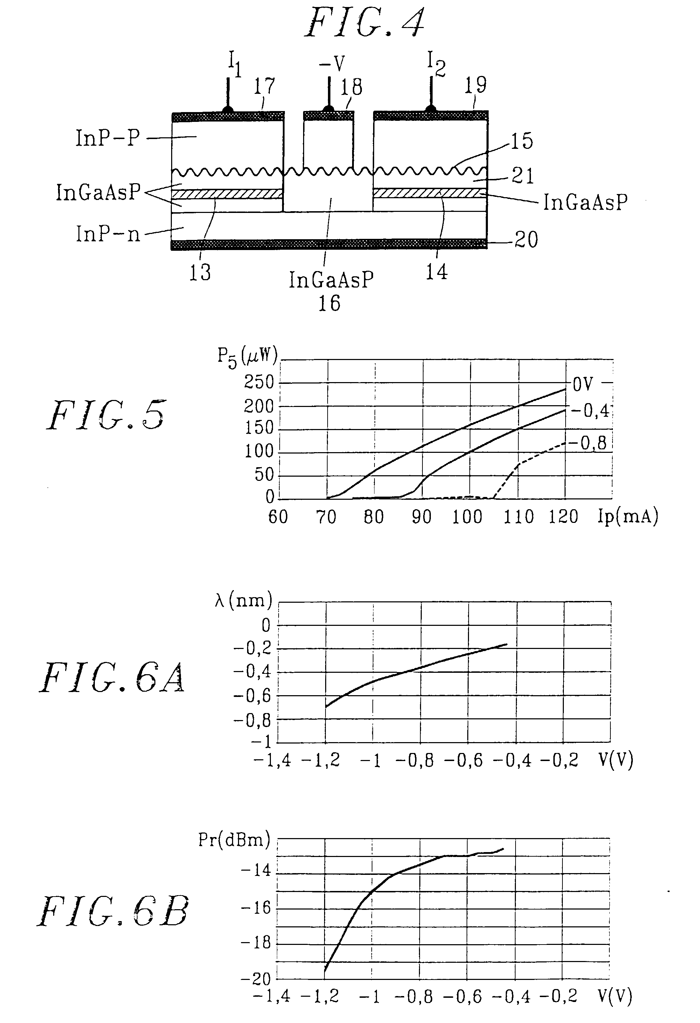

Afin de vérifier le principe du fonctionnement de l'invention, une structure basée sur une structure BRS ("Buried Ridge Structure" ou structure à ruban enterré) décrite dans la référence [7] a été réalisée, comme représenté à la figure 4. Cette première structure comporte trois sections : deux sections latérales amplificatrices pour λ = 1,55 µm comportant une couche active (λ_{g} = 1,55 µm) et une section centrale électroabsorbante pour λ = 1,55 µm (λ_{g} = 1,47 µm). Un réseau de pas 240 nm (dont la longueur d'onde de Bragg est de 1,55 µm) qui est gravé dans une couche de confinement 21 (couche supérieure aux couches actives) rétrodiffuse la lumière à 1,55 µm. La longueur respective de la section amplificatrice, la section centrale et la section amplificatrice est typiquement de 160 µm, 60 µm et 160 µm. La lumière issue des sections amplificatrices est couplée au travers de la section centrale qui est, sans polarisation en inverse, transparente à 1,55 µm. De ce fait, l'ensemble fonctionne comme un laser DFB émettant à 1,55 µm quand les sections latérales sont polarisées en direct. L'application d'une tension en inverse sur la section centrale provoque une augmentation de l'absorption due à l'effet Franz-Keldysh. La séparation électrique des électrodes est réalisée par une combinaison d'une gravure sèche RIBE ("Reactive Ion Beam Etching" ou gravure à faisceau d'ions réactifs) et d'une attaque chimique. Une gravure profonde (jusqu'à la première couche quaternaire) permet d'obtenir une résistance de séparation de 2 KΩ. Une implantation de protons dans les régions latérales du ruban formé par l'ensemble des couches actives 13, 14 et de la couche électroabsorbante 16 permet de diminuer le courant de fuite et la capacité parasite. Une capacité de 4 pF/100 µm et un courant de fuite inférieur à de 1 µA ont été obtenus à -1 V.

La figure 5 montre la puissance de sortie du laser illustré à la figure 4 en fonction du courant de polarisation Ip(= I₁ + I₂) pour différentes tensions en inverse appliquées sur la section électroabsorbante. Elle met en évidence une augmentation du courant de seuil accompagnée d'une diminution de la puissance optique.

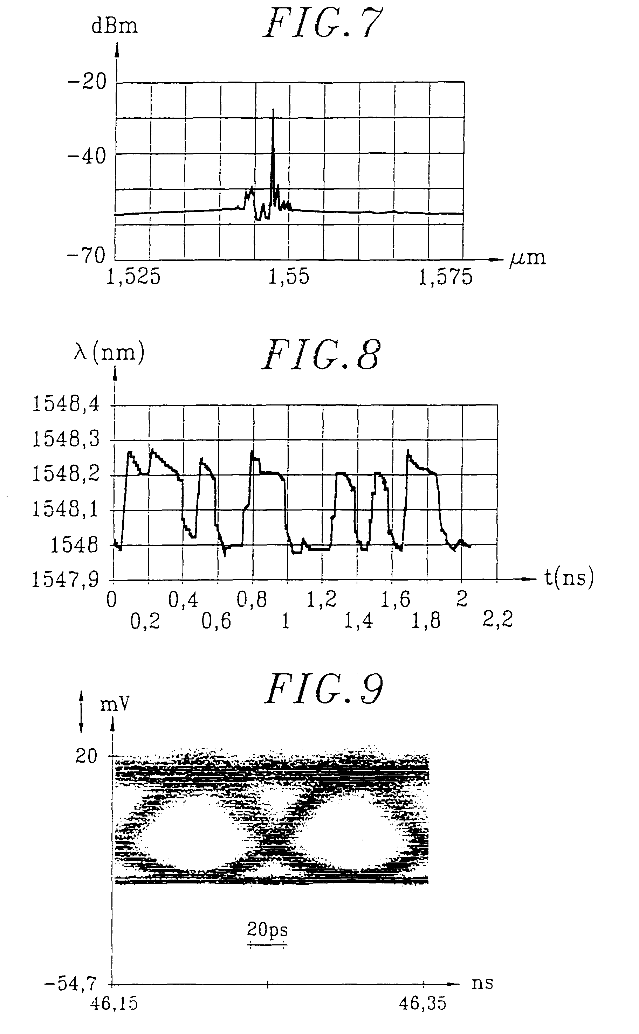

Les figures 6A et 6B montrent l'effet de la tension en inverse sur respectivement la longueur d'onde d'émission et la puissance optique. Ces figures représentent respectivement la variation de longueur d'onde en fonction de la tension en inverse V et la puissance relative Pr en fonction de cette tension. Les mesures ont été réalisées en appliquant une tension en inverse impulsionnelle de 1 Gbit/s avec une longueur de mot de 16 bits sur un laser fonctionnant à I = 120 mA. De ce fait, une puissance relative de -12 dB correspond à une différence nulle. L'application d'une tension en inverse de -1 V permet d'obtenir une diminution de la longueur d'onde de 0,5 nm tout en maintenant à moins de 3 dB une diminution de la puissance optique. Un spectre d'émission à 71 mA est présenté dans la figure 7.

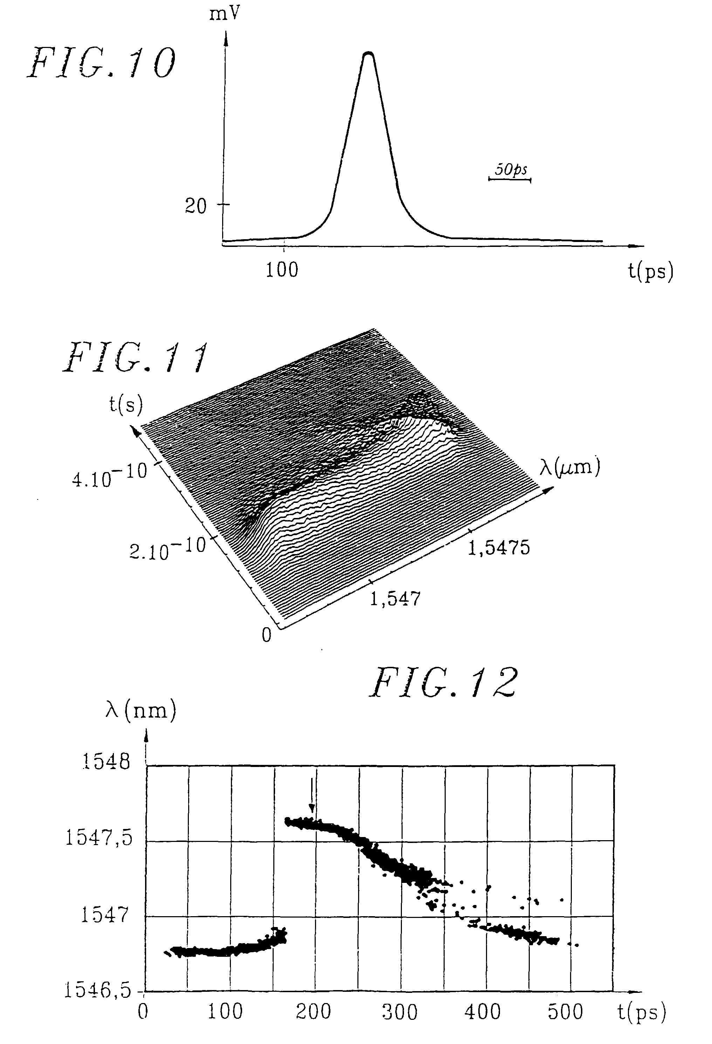

Le temps de commutation du dispositif a été mesuré en appliquant un signal pseudo-aléatoire NRZ (longueur de mot de 2⁷-1) de 10 Gbits/s. La figure 8 met en évidence une variation de la longueur d'onde λ obtenue avec ce signal. C'est un format en modulation de longueur d'onde. Les longueurs d'onde de départ et d'arrivée correspondent respectivement aux valeurs numériques 0 et 1. L'amplitude du signal étant de -0,7 V, on observe un temps de commutation inférieur à 100 ps aussi bien pour les fronts montants que les fronts descendants. Le filtrage d'une des longueurs d'onde permet de détecter le signal généré en modulation de longueur d'onde.

La figure 9 montre un diagramme de l'oeil obtenu en détectant les 0. Une tension NRZ (2³¹-1) 10 Gbits/s de -0,4 V est appliquée. L'efficacité de modulation (nm/V) est de 0,4 nm/V environ pour ce laser et la meilleure valeur est de 0,9 nm/V (ou 5,6 GHz/mA).

Des impulsions optiques sont générées en appliquant une tension en inverse périodique sur la section centrale. Le laser est polarisé de façon qu'il y ait effet laser au moment où la tension est nulle. Le courant de polarisation est optimisé en observant la forme des impulsions optiques. Un générateur de mots est utilisé comme source de tension périodique. La largeur temporelle des impulsions est mesurée pour des débits de 5 Gbits/s à 10 Gbits/s, la largeur minimale étant de 40 ps.

La figure 10 montre la forme temporelle des impulsions optiques mesurée avec une photodiode ayant une bande passante de 32 GHz et un oscilloscope de 20 GHz. La largeur est de 52 ps.

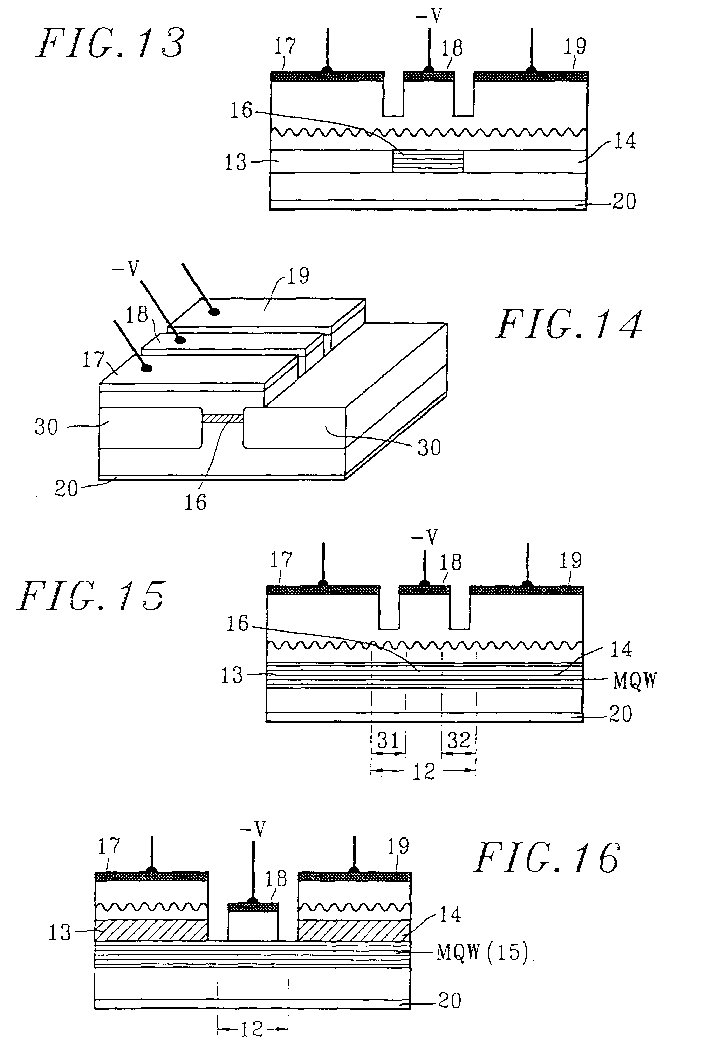

La figure 11 présente la répartition spectro-temporelle de la puissance optique d'une impulsion mesurée avec la technique de spectre résolu en temps.

La figure 12 montre une évolution temporelle de la longueur d'onde correspondant à la puissance maximale à un instant donné. La flèche indique la position temporelle correspondant à la puissance maximale d'une impulsion. On observe un très faible chirp (≈ 0,03 nm) autour de la puissance maximale. Une limitation spectrale par un filtre permettra d'obtenir des impulsions à la limite de Fourier (Solitons).

### Structure évoluée

- Section absorbante 16 à puits quantiques multiples (MQW) illustrée à la figure 13 : on utilise l'effet Franz-Keldysh pour réaliser les premiers dispositifs avec une section centrale électroabsorbante. L'utilisation des effets associés à des structures puits quantiques tels que l'effet Stark quantique confiné, Wannier-Stark (voir référence [8]) ou encore BRAQWET (voir référence [9]) permet de perfectionner le dispositif tout en gardant le même principe de fonctionnement. Seuls les procédés de fabrication sont différents.
- Structure avec semi-isolant ; des couches semi-isolantes InP 30 étant illustrées à la figure 14 : une des structures les plus efficaces pour obtenir une faible capacité parasite est sans aucun doute une structure réalisée en utilisant efficacement un semi-isolant InP. L'utilisation de ce dernier à la place de InP-p, notamment au voisinage latéral du ruban, permet de diminuer à la fois la capacité parasite et le courant de fuite (en inverse et en direct) grâce à une meilleure isolation électrique. Une telle contribution est appréciable notamment pour l'obtention de dispositifs rapides.
- Structure obtenue par épitaxie sélective en surface illustrée à la figure 15 : une structure basée sur le couplage bout à bout nécessite une épitaxie localisée pour réaliser la section électroabsorbante 16. Une des possibilités de fabriquer une telle structure consiste à utiliser la technique de l'épitaxie sélective en surface. L'utilisation de cette technique permet de réaliser des dispositifs qui correspondent sensiblement au schéma du principe illustré à la figure 1. Dans ce cas, le couplage entre les sections latérales 1,55 µm (10 et 11 dans la figure 1 et 13 et 14 dans la figure 15) et la section électroabsorbante se fait d'une façon progressive dans des zones de transition 31 et 32. L'épitaxie localisée consiste en une croissance localisée des matériaux alors que l'épitaxie sélective en surface réalise une croissance des matériaux dont l'énergie de bande interdite ("Gap") dépend de la forme géométrique et de la surface du masque utilisé. Ceci permet d'obtenir une structure horizontale composée de plusieurs matériaux de "Gap" différent en une seule étape épitaxiale. Cette technique peut contribuer d'une façon déterminante à la réalisation de dispositifs les plus performants.
- Structure à couplage évanescent : cette structure permet de diminuer le nombre d'étapes technologiques. Le dispositif comporte également trois sections. Deux sections amplificatrices et un guide électroabsorbant sont empilés, comme illustré à la figure 16. La lumière issue des sections amplificatrices (13 et 14) est couplée d'une façon évanescente au guide électroabsorbant (15). L'effet électroabsorbant est obtenu en appliquant une tension en inverse sur la partie centrale du guide (12). Le guide peut être réalisé en matériaux massifs ou en puits quantiques.

### Applications

### Emetteur du signal modulé en longueur d'onde (ou en fréquence) très haut débit (> 10 Gb/s)

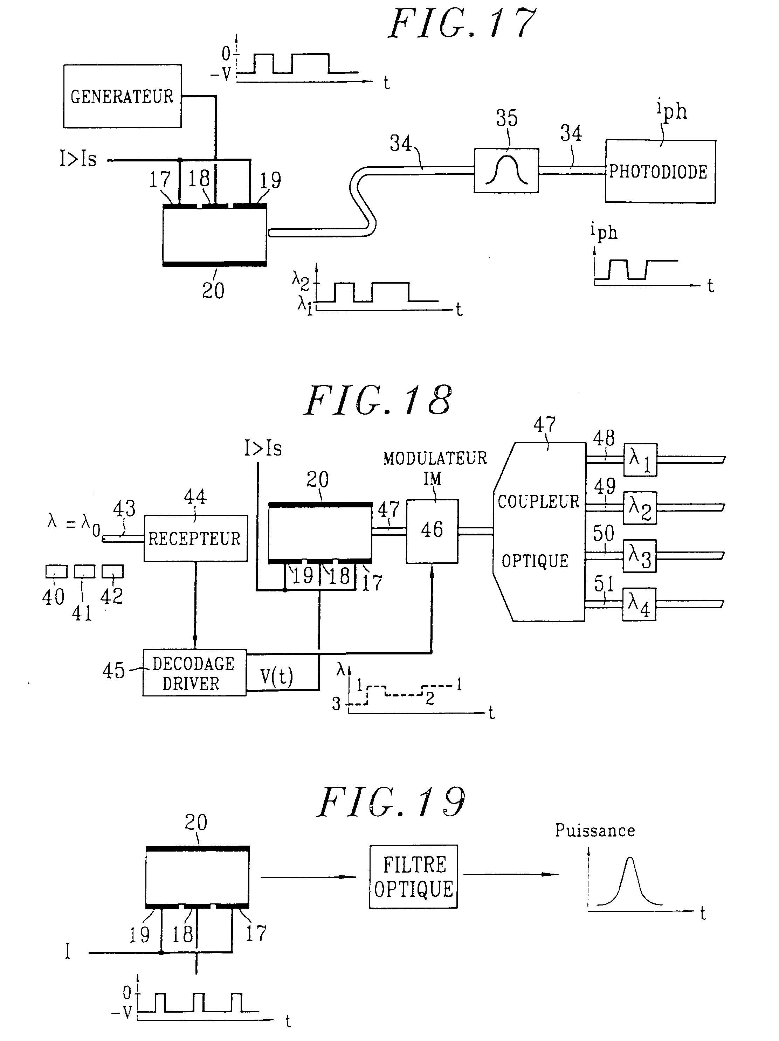

L'utilisation du dispositif de l'invention comme émetteur, illustrée à la figure 17, permet de réaliser une liaison haut débit en modulation de longueur d'onde (WSK) ou en fréquence (FSK) pour une faible modulation. Afin de restituer le signal électrique, le signal optique reçu, qui est véhiculé dans une fibre optique 34, est filtré (35) à la longueur d'onde de base (λ1) (ou à la fréquence de base) par un filtre optique et est détecté par une photodiode placée à la sortie du filtre. Le signal électrique de la photodiode est proportionnel au signal d'origine.

### Commutateur de longueurs d'onde très rapide (< 100 ps)

Une très bonne efficacité de modulation de longueur d'onde (≈ 0,9 nm/V ou 112 GHz/V) du dispositif de l'invention est mise en valeur dans des systèmes de distribution utilisant plusieurs longueurs d'onde (multicolore). Un exemple de réalisation est un commutateur de longueurs d'onde des cellules ATM ("Asynchronous Transfer Mode" ou mode de transfert asynchrone) 40, 41, 42 illustré à la figure 18.

Le signal véhiculé sur une fibre 43 est reçu par un récepteur 44 relié à un décodage "driver" 45 qui, d'une part envoie un signal V(t) sur l'électrode centrale 18 du dispositif de l'invention et d'autre part une modulation signal à un modulateur IM 46 qui reçoit le signal sortant du dispositif de l'invention via une fibre optique 47 et qui envoie son signal de sortie sur un coupleur optique 47, lui-même relié en sortie à plusieurs fibres optiques 48, 49, 50, 51, sur lesquelles sont disposées des filtres optiques à des longueurs d'onde λ1, λ2, λ3 et λ4.

Ce dispositif affecte une longueur d'onde distincte à chacune des cellules ATM. Le changement de la longueur d'onde s'effectue entre deux cellules successives (temps de garde). Ce changement peut être réalisé en moins de 100 ps qui est le temps bit pour un signal de 10 Gb/s. Après ce changement, les cellules peuvent être aiguillées sur différentes destinations. Le nombre de longueurs d'onde utilisable est déterminé par la plage d'accord divisée par l'espacement de canaux. Avec une tension de -2V, on obtient une plage de 1,8 nm, ce qui correspond à 7 canaux espacés de 0,3 nm.

### Emetteur d'impulsions optiques (du type soliton) haut débit (> 5 Gb/s)

Le dispositif de l'invention, illustré à la figure 19, fonctionne comme émetteur d'impulsions optiques quand sa section électroabsorbante est modulée par une tension en inverse périodique (voir plus haut). Le filtrage du signal optique autour de la longueur d'onde à laquelle la puissance optique est maximale permet d'obtenir des impulsions à la limite de Fourier (≈ soliton).

### REFERENCES

[1] F. Delorme, B. Rose, A. Ramdane, B. Pierre et H. Nakajima, "Ultra-Fast Electro-Optical Distributed Bragg Reflector Laser For Optical Switching", Int. Conf. Semiconductor Lasers, Maui (USA), Paper Th2.2, Septembre 1994
[2] S. Kuwano, Y. Tada et N. Shibata, "100 ps Frequency Switching Without Bit Loss For A 10 Gb/s ASK Modulated Signal", IEEE Photon. Techno. Lett., 5, pages 354-356
[3] M. Blez, D. Mathoorasing, C. Kazmierski, A. Ougazzaden, Y. Sorel, I.F. de Faria, D. Robein, G. Lemestreallan et J. Landreau, "20 kHz-18 GHz FM Bandwidth Single-Section MQW VUG DFB Lasers With FM Efficiency Higher Than 0.9 GHz/mA", Int. Conf. Indium Phosphide and Related Materials, Paris (France), Paper WD5, avril 1993
[4] M. Bleez, D. Mathoorasing, C. Kazmierski, E. Ravis, A. Ougazzaden, G. Lemestreallan et D. Robein, "2 Sections MQW VUG DFB Lasers With 18 GHz Bandwidth And 1.5 GHz/mA FM Efficiency", Int. Conf. Indium Phosphide And Related Materials, Santa Barbara (USA), Paper WP20, Mars 1994
[5] L.V. Keldysh, O.V. Konstantinov et V.I. Perel, "Polarization Effects In the Interband Absorption Of Light In Semiconductors Subjected To A Strong Electric Field", Sov. Phys. Semiconductors, 3, pages 876-884 (1970)
[6] D.A.B. Miller, D.S. Chemla, T.C. Damen, A.C. Gossard, W. Wiegmann, T.H. Wood et C.A. Burrus, "Band-Edge Electroabsorption In Quantum Well Structures : The Quantum-Confined Stark Effect", Phys. Rev. Lett., 53, pages 2173-2176 (1984)
[7] J. Charil, S. Slempkes, D. Robein, C. Kazmierski et J.C. Bouley, "Extremely Low Threshold Operation Of 1.5 µm GaInAsP/InP Buried Ridge Stripe Lasers", Electron. Lett., 25, pages 1477-1479 (1989)
[8] P. Voisin, "Wannier-Stark Quantization And Its Applications To Electro-Optical Modulation", Superlattices And Microstructures, 8, pages 323-327 (1990)
[9] J.E. Zucker, T.Y. Chang, M. Wegener, N.J. Sauer, K.L. Jones et D.S. Chemla, "Large Refractive Index Changes In Tunable-Electron-Density InGaAs/InAlAs Quantum Wells", IEEE Photon. Techn. Lett., 2, pages 29-31 (1990)
[10]G.P. Agrawal et N.K. Dutta, "Long-Wavelength Semiconductor Lasers", Van Nostrand Reinhold Company, New York, chapitre 6, pages 220-227

## Revendications

1. Dispositif d'émission semi-conducteur avec modulation rapide de longueur d'onde, caractérisé en ce qu'il est composé de trois sections : deux sections latérales (10, 11) qui comportent chacune une couche active (13, 14) et un réseau DFB (15) et qui produisent un gain optique, reliées au travers d'une section centrale (12) comprenant une couche électroabsorbante (16) à laquelle est appliquée une tension en inverse (-V) qui permet de modifier quasi-instantanément le taux d'absorption dans cette section.

2. Dispositif selon la revendication 1, caractérisé en ce qu'une séparation électrique des électrodes est réalisée par une combinaison d'une gravure sèche RIBE et d'une attaque chimique.

3. Dispositif selon la revendication 2, caractérisé en ce qu'une gravure profonde permet d'obtenir une résistance de séparation de 2 KΩ.

4. Dispositif selon la revendication 2, caractérisé en ce qu'une implantation de protons dans les régions latérales du ruban formé par les couches actives (13, 14) et par la couche électroabsorbante (16) permet de diminuer le courant de fuite et la capacité parasite.

5. Dispositif selon la revendication 1, caractérisé en ce que des impulsions optiques sont générées en appliquant une tension en inverse périodique sur la section centrale, le laser étant polarisé de façon qu'il y ait effet laser au moment où la tension est nulle.

6. Dispositif selon la revendication 1, caractérisé en ce que la section centrale absorbante est une section absorbante à puits quantiques multiples.

7. Dispositif selon la revendication 1, caractérisé en ce qu'on utilise un semi-isolant de type InP au voisinage latéral du ruban formé par les couches actives (13, 14) et par la couche électroabsorbande (16).

8. Dispositif selon la revendication 1, caractérisé en ce qu'on utilise une technique d'épitaxie sélective en surface.

9. Dispositif selon la revendication 1, caractérisé en ce que la lumière issue des deux sections latérales (10, 11) est couplée d'une façon évanescente à la couche électroabsorbante.

10. Dispositif selon l'une quelconque des revendications précédentes, caractérisé en ce qu'il est utilisé dans un émetteur de signal modulé en longueur d'onde, ou en fréquence, très haut débit.

11. Dispositif selon l'une quelconque des revendications 1 à 9, caractérisé en ce qu'il est utilisé dans une commutateur de longueur d'onde très rapide.

12. Dispositif selon l'une quelconque des revendications 1 à 9, caractérisé en ce qu'il est utilisé dans un émetteur d'impulsions optiques haut débit.

## Patentansprüche

1. Halbleitende Emissionsvorrichtung mit schneller Wellenlängenmodulation,
**dadurch gekennzeichnet**,
dass sie durch drei Sektionen gebildet wird: zwei seitlichen Sektionen (10, 11), jede eine aktive Schicht (13, 14) und ein DFB-Gitter (15) umfassend, die eine optische Verstärkung erzeugen und verbunden sind durch eine mittlere Sektion (12), die eine elektroabsorbierende Schicht (16) umfasst, an die eine invertierte Spannung (-V) gelegt wird, die ermöglicht, den Absorptionsgrad in dieser Sektion quasi-momentan bzw. sofort zu modifizieren.

2. Vorrichtung nach Anspruch 1, dadurch gekennzeichnet, dass eine elektrische Trennung der Elektroden durch eine Kombination aus einer Trockenätzung RIBE und einem chemischen Angriff erfolgt.

3. Vorrichtung nach Anspruch 2, dadurch gekennzeichnet, dass eine tiefe Ätzung ermöglicht, einen Trennungswiderstand von 2 kΩ zu erzielen.

4. Vorrichtung nach Anspruch 2, dadurch gekennzeichnet, dass eine Protonenimplantantion in den seitlichen Bereichen des durch die aktiven Schichten (13, 14) und durch die elektroabsorbierende Schicht (16) gebildeten Streifens ermöglicht, den Streustrom und die Störkapazität zu reduzieren.

5. Vorrichtung nach Anspruch 1, dadurch gekennzeichnet, dass optische Impulse erzeugt werden, indem eine periodische invertierte Spannung an die mittlere Sektion gelegt wird, wobei der Laser derart polarisiert bzw. vorgespannt wird, dass der Lasereffekt zum dem Zeitpunkt erfolgt, wo die Spannung null ist.

6. Vorrichtung nach Anspruch 1, dadurch gekennzeichnet, dass die absorbierende mittlere Sektion eine Sektion mit vielen Quantentöpfen ist.

7. Vorrichtung nach Anspruch 1, dadurch gekennzeichnet, dass man in der seitlichen Umgebung des durch die aktiven Schichten (13, 14) und durch die elektroabsorbierende Schicht (16) gebildeten Streifens einen Halbisolator des Typs InP verwendet.

8. Vorrichtung nach Anspruch 1, dadurch gekennzeichnet, dass man eine Technik selektiver Oberflächenepitaxie benutzt.

9. Vorrichtung nach Anspruch 1, dadurch gekennzeichnet, dass das aus den beiden seitlichen Sektionen (10, 11) austretende Licht auf eine abklingende Weise in die elektroabsorbierende Schicht eingekoppelt wird.

10. Vorrichtung nach einem der vorangehenden Ansprüche, dadurch gekennzeichnet, dass sie in einem wellenlängen- oder frequenzmodulierten Signalemitter mit sehr hoher Leistung verwendet wird.

11. Vorrichtung nach einem der Ansprüche 1 bis 9, dadurch gekennzeichnet, dass sie in einem sehr schnellen Wellenlängenumschalter verwendet wird.

12. Vorrichtung nach einem der Ansprüche 1 bis 9, dadurch gekennzeichnet, dass sie in einem Hochleistungs-Lichtimpulsemitter verwendet wird.

## Claims

1. Semiconductor emission device with fast wavelength modulation, characterized in that it is constituted by three sections, namely two lateral sections (10, 11), each having an active layer (13, 14) and a DFB network (15) and which produce an optical gain, connected across a central section (12), which incorporates an electroabsorbant layer (16), to which is applied a reverse voltage (-V) making it possible to quasi-instantaneously modify the absorption rate in said section.

2. Device according to claim 1, characterized in that an electrical separation of the electrodes is brought about by a combination of RIBE and chemical etching.

3. Device according to claim 2, characterized in that a deep etching leads to a separation resistance of 2 KΩ.

4. Device according to claim 2, characterized in that an implantation of protons in the lateral regions of the stripe formed by the active layers (13, 14) and by the electroabsorbant layer (16) makes it possible to reduce the leakage current and the stray capacitance.

5. Device according to claim 1, characterized in that optical pulses are generated by applying a periodic reverse voltage to the central section, the laser being biased in such a way that a laser effect occurs at the instant when the voltage is zero.

6. Device according to claim 1, characterized in that the central absorbant section is a multiple quantum well absorbant section.

7. Device according to claim 1, characterized in that use is made of an InP-type semi-insulant in the lateral vicinity of the stripe formed by the active layers (13, 14) and the electroabsorbant layer (16).

8. Device according to claim 1, characterized in that use is made of a selective surface epitaxy method.

9. Device according to claim 1, characterized in that the light from the two lateral sections (10, 11) is coupled in evanescent manner to the electroabsorbant layer.

10. Device according to any one of the preceding claims, characterized in that it is used in a very fast frequency or wavelength modulated signal emitter.

11. Device according to any one of the claims 1 to 9, characterized in that it is used in a very fast wavelength switch.

12. Device according to any one of the claims 1 to 9, characterized in that it is used in a very fast optical pulse emitter.
